# DEMANDE DE BREVET EUROPEEN

(11) **EP 2 348 632 A1**
(43) Date de publication de la demande: **27.07.2011**
(21) Numéro de dépôt: 10197011.9
(22) Date de dépôt: 24.12.2010
(51) Int. Cl.: H03F 3/193

(54) **Amplificateur déphaseur**

(30) Priorité: 14.01.2010 FR 1050249
(71) Demandeur: STMicroelectronics SA, 92120 Montrouge (FR)
(72) Inventeur: Martineau, Baudouin, 38000 Grenoble (FR); Richard, Olivier, 38850 Bilieu (FR)
(74) Mandataire: de Beaumont, Michel

(57) **Abrégé**

L'invention concerne un amplificateur cascode comportant au moins deux étages déphaseurs commandables (7ⱼ) entre un transistor d'entrée (M61) dont une borne de commande est connectée à une borne d'entrée (62) de l'amplificateur, et une borne de sortie (66) de l'amplificateur.

## Description

### Domaine de l'invention

La présente invention concerne de façon générale les circuits électroniques et, plus particulièrement, les chaînes d'émission-réception radiofréquence.

L'invention s'applique plus particulièrement aux chaînes d'émission à mise en forme de faisceaux (beamforming) destinées à des antennes adaptatives.

### Exposé de l'art antérieur

Les chaînes de transmission radiofréquence sont quasi-systématiquement équipées d'amplificateurs à gain réglable et, de plus en plus souvent, associées à des déphaseurs pour diriger le rayonnement d'une antenne adaptative.

Le recours à des antennes adaptatives permet de créer un faisceau résultant dans la direction de l'émetteur ou du récepteur et de focaliser la transmission pour, par exemple, accroître la portée dans la direction de l'autre système avec lequel la chaîne de transmission communique.

Les antennes adaptatives sont généralement formées de plusieurs antennes directives associées chacune individuellement à une voie d'émission ou de réception. Chaque voie comporte un déphaseur pour ajuster la phase du signal envoyé sur l'antenne correspondante. Les différentes voies sont commandables individuellement en fonction de la direction souhaitée pour la transmission.

Une technique connue consiste à déphaser les signaux de la porteuse de modulation ou de démodulation (oscillateur local). Il faut alors autant de modulateurs (ou démodulateurs) que de voies, ce qui engendre une consommation importante en raison du nombre d'amplificateurs et de circuits requis.

Une autre technique connue consiste à déphaser les signaux en bande de base, c'est-à-dire les signaux analogiques après démodulation (en réception) ou avant modulation (en émission). Là encore, il faut prévoir autant de modulateurs que de voies.

Une autre technique consiste à déphaser les signaux radiofréquence après modulation ou avant démodulation. Les déphaseurs sont alors réalisés en lignes distribuées associées à des commutateurs, ce qui est également encombrant.

### Résumé

Un objet d'un mode de réalisation de la présente invention est de proposer une chaîne de transmission radiofréquence à mise en forme de faisceau qui pallie tout ou partie des inconvénients des techniques usuelles.

Un autre objet d'un mode de réalisation vise une solution de moindre consommation et moins encombrante que les techniques usuelles.

Un autre objet d'un mode de réalisation de la présente invention vise plus généralement à proposer un amplificateur déphaseur à phase réglable.

Un autre objet d'un mode de réalisation de la présente invention vise un amplificateur à phase et gain réglables.

Pour atteindre tout ou partie de ces objets ainsi que d'autres, la présente invention prévoit un amplificateur cascode comportant au moins deux étages déphaseurs commandables entre un transistor d'entrée dont une borne de commande est connectée à une borne d'entrée de l'amplificateur, et une borne de sortie de l'amplificateur.

Selon un mode de réalisation de la présente invention, chaque étage déphaseur comporte un élément de gain en série avec un élément retardateur entre ladite borne de sortie et ledit transistor d'entrée, chaque élément retardateur reliant le point milieu de ladite connexion en série à l'élément retardateur de l'étage de rang précédent.

Selon un mode de réalisation de la présente invention, chaque élément de gain comporte au moins un transistor reliant ladite borne de sortie à l'élément retardateur de l'étage correspondant.

Selon un mode de réalisation de la présente invention, chaque élément de gain comporte plusieurs transistors en parallèle pour rendre le gain de l'amplificateur réglable.

Selon un mode de réalisation de la présente invention, les transistors des éléments de gain sont des transistors MOS.

Selon un mode de réalisation de la présente invention, le transistor d'entrée est un transistor MOS monté en source commune.

Selon un mode de réalisation de la présente invention, le transistor d'entrée est un transistor bipolaire monté en émetteur commun.

On prévoit également une chaîne de transmission radiofréquence à antenne adaptative, comportant au moins un amplificateur déphaseur.

Selon un mode de réalisation de la présente invention, la chaîne de transmission comporte :
côté émission, un premier amplificateur déphaseur formant un premier étage d'un amplificateur d'émission ; et
côté réception, un deuxième amplificateur déphaseur formant un dernier étage d'un amplificateur à faible bruit.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est un schéma bloc d'un mode de réalisation d'un système de transmission du type auquel s'applique à titre d'exemple la présente invention ;
la figure 2 représente un mode de réalisation d'un amplificateur déphaseur selon la présente invention ;
la figure 3 représente le schéma électrique d'un élément de commutation de l'amplificateur de la figure 2 ;
la figure 4 illustre, par des allures simplifiées d'un signal, le fonctionnement de l'amplificateur déphaseur de la figure 2 ;
la figure 5 est un schéma bloc partiel illustrant des variantes de réalisation de l'amplificateur déphaseur de la figure 2 ;
la figure 6 représente, de façon schématique, un mode de réalisation d'un amplificateur de réception à faible bruit ;
la figure 7 représente, de façon schématique, un mode de réalisation d'un amplificateur d'émission ;
les figures 8A et 8B représentent partiellement et schématiquement un mode de réalisation d'une chaîne d'émission pour une antenne adaptative omnidirectionnelle et la mise en forme de faisceau obtenue ;
la figure 9A et 9B représentent partiellement et schématiquement un mode de réalisation d'une chaîne d'émission pour deux antennes adaptatives rayonnant chacune sur 180° et la mise en forme de faisceau obtenue ; et
la figure 10 représente un mode de réalisation d'un amplificateur déphaseur différentiel.

### Description détaillée

De mêmes éléments ont été désignés par de mêmes références aux différentes figures. Pour des raisons de clarté, seuls les éléments utiles à la compréhension de l'invention ont été représentés et seront décrits. En particulier, la génération des signaux à émettre et l'exploitation des signaux reçus n'a pas été détaillée, l'invention étant compatible avec toute chaîne de transmission usuelle. De plus, la constitution des antennes adaptatives ou des réseaux d'antennes exploitables avec les modes de réalisation qui vont être décrits n'a pas été détaillée, l'invention ne nécessitant aucune modification de ces antennes adaptatives ou réseaux d'antennes.

L'invention sera décrite par la suite en relation avec un exemple d'application à une chaîne de transmission radiofréquence. On notera qu'elle s'applique toutefois plus généralement à la réalisation d'un amplificateur déphaseur à phase réglable. Par exemple, l'invention s'applique à des récepteurs de type superhétérodyne, à des chaînes à conversion directe, à des chaînes radio à impulsions, etc.

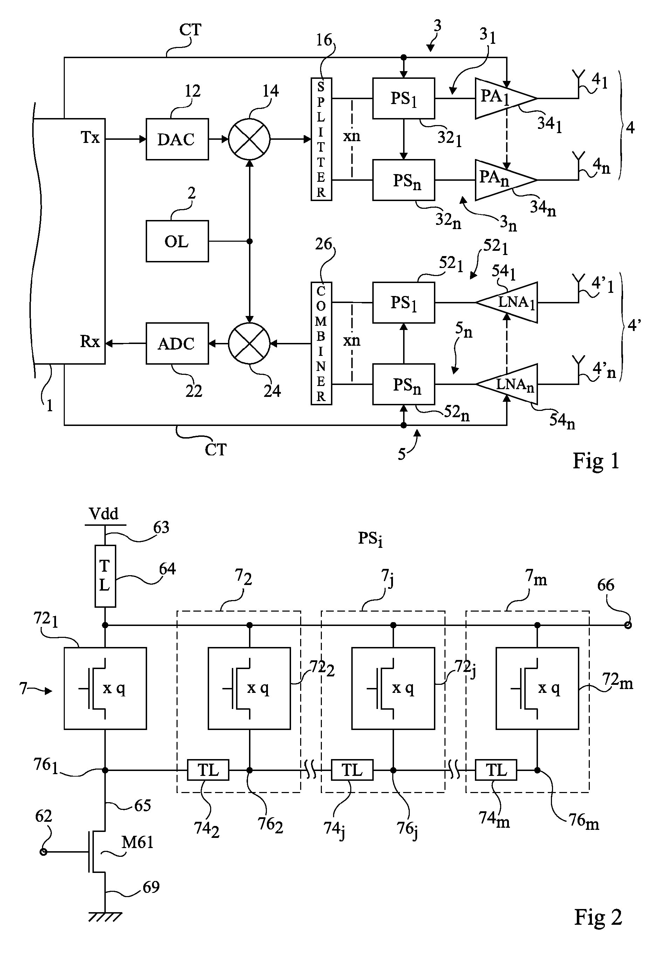

La figure 1 est un schéma bloc d'un mode de réalisation d'un système de transmission radiofréquence du type auquel s'applique à titre d'exemple la présente invention.

Côté émission, un signal Tx à transmettre est mis en forme par un circuit électronique de transmission 1. Ce circuit est par exemple un microcontrôleur ou tout autre circuit de mise en forme de données à transmettre. Le signal numérique issu du circuit 1 est converti par un convertisseur numérique/analogique 12 (DAC) pour servir de signal de modulation à une porteuse fournie par un oscillateur local 2 (OL) à un modulateur 14. La sortie du modulateur 14 est envoyée sur un circuit 3 d'amplification et de mise en forme de faisceau dont le rôle est d'adapter le gain et la phase du signal pour focaliser l'émission d'une antenne adaptative vers le récepteur auquel est destinée la transmission.

Dans l'exemple de la figure 1, on suppose l'utilisation d'un réseau 4 de plusieurs (n) antennes adaptatives 4₁,..., 4ₙ de rayonnement limité. Par conséquent, le circuit 3 comprend autant (n) de voies 3₁,..., 3ₙ que le réseau 4 comporte d'antennes adaptatives. Toutefois, comme on le verra par la suite, le nombre de voies du réseau dépend de l'angle de rayonnement de l'antenne. Une seule voie (n=1) suffit pour une antenne adaptative omnidirectionnelle. Dans le cas de plusieurs antennes, le signal issu du modulateur 14 traverse un séparateur 16 (SPLITTER) pour distribuer le signal vers toutes les voies 3i (i étant compris entre 1 et n).

Chaque voie d'émission comporte un amplificateur déphaseur 32i (32ᵢ, ..., 32ₙ - PS₁, ..., PSₙ) associé à un amplificateur de puissance 34ᵢ (34₁, ..., 34ₙ - PA₁, ..., PAₙ). Comme on le verra par la suite, le circuit déphaseur forme préférentiellement un étage de l'amplificateur d'émission. La sortie de chaque amplificateur d'émission (voie 3i) est envoyée sur l'antenne 4i de la voie concernée. Les amplificateurs déphaseurs 32ᵢ et de puissance 34ᵢ reçoivent, du microcontrôleur 1, des signaux de commande CT destinés à fixer la phase et le gain. Ces signaux de commande sont générés à partir de mesures effectuées par des coupleurs (non représentés) intercalés sur les lignes de transmission, généralement le plus près possible des antennes.

Côté réception, un réseau 4' d'antennes similaires 4'₁,...4'ₙ capte un signal. Les antennes ont été représentées distinctes de celles d'émission mais peuvent être les mêmes pour l'émission et la réception. C'est pourquoi leur nombre est identique. Le signal capté est transmis à un circuit 5 d'amplification et de mise en forme comportant n (n étant supérieur ou égal à 1) voies de réception pourvues, chacune, d'un amplificateur à faible bruit 54ᵢ (54₁, ..., 54ₙ - LNA₁, ..., LNAₙ) suivi d'un déphaseur 52ᵢ (52₁, ..., 52ₙ - PS₁, ..., PSₙ). Comme on le verra par la suite, le circuit déphaseur forme préférentiellement un étage de l'amplificateur à faible bruit. Les sorties des amplificateurs-déphaseurs 52i sont envoyées à un combineur 26 (COMBINER) dont la sortie est envoyée sur un démodulateur 24 recevant également le signal issu de l'oscillateur local 2. La sortie du démodulateur 24 est convertie par un convertisseur analogique-numérique 22 (ADC) dont la sortie est envoyée sur le microcontrôleur 1 (signal Rx). Comme pour l'émission, les amplificateurs (à faible bruit et déphaseur) reçoivent des signaux de commande CT du microcontrôleur 1 pour ajuster la phase et le gain.

Comme le faisceau de réception a la même direction que le faisceau d'émission, le microcontrôleur 1 sélectionne le même déphasage en émission et en réception.

Bien que cela n'ait pas été représenté, que ce soit côté émission ou côté réception, d'autres circuits d'adaptation d'impédance, de couplage, etc. sont présents dans les chaînes d'émission-réception.

La figure 2 représente un mode de réalisation d'un amplificateur déphaseur PSᵢ. La structure décrite en relation avec la figure 2 peut indifféremment constituer l'un des amplificateurs déphaseur d'émission 32ᵢ ou de réception 52ᵢ du système de la figure 1.

L'architecture de ce circuit est basé sur une structure de type cascode. Un transistor MOS à source commune M61 (source connectée à une borne 69 de masse) reçoit, sur sa grille, le signal à amplifier-déphaser qui provient d'une borne 62 d'entrée du circuit. Le drain 65 du transistor M61 est relié à un circuit 7 fixant la phase et le gain, en série avec une charge 64 (par exemple une ligne de transmission TL) entre le drain 65 du transistor M61 et une borne 63 d'application d'un potentiel positif d'alimentation (Vdd). Le point milieu entre la charge 64 et l'étage 7 définit une borne de sortie 66 de l'amplificateur déphaseur.

Le circuit 7 comporte, en parallèle entre le drain 65 du transistor M61 et la borne 66, un nombre m d'étages déphaseurs référencé 7ⱼ (j étant compris entre 2 et m) en fonction du nombre de sauts de phase prévus pour le circuit déphaseur. Chaque étage déphaseur 7ⱼ comporte un élément de gain 72ⱼ en série avec un élément retardateur 74ⱼ entre la borne de sortie 66 et le point milieu 76ⱼ₋₁ de l'association en série de l'étage déphaseur 7ⱼ₋₁ de rang inférieur. Chaque élément retardateur 74ⱼ est constitué, par exemple, d'une ligne de transmission (TL) dont la longueur dépend du déphasage entre deux cônes du faisceau à mettre en forme, le retard apporté par le premier étage 7₁ étant nul (en pratique, limité à un retard de propagation négligeable entre le drain du transistor 62 et l'élément de gain 72₁). Un seul élément de gain est rendu passant à la fois. Cela fixe le nombre d'éléments retardateur 74ⱼ en série entre le drain 65 du transistor à source commune M61 et la borne de sortie 66.

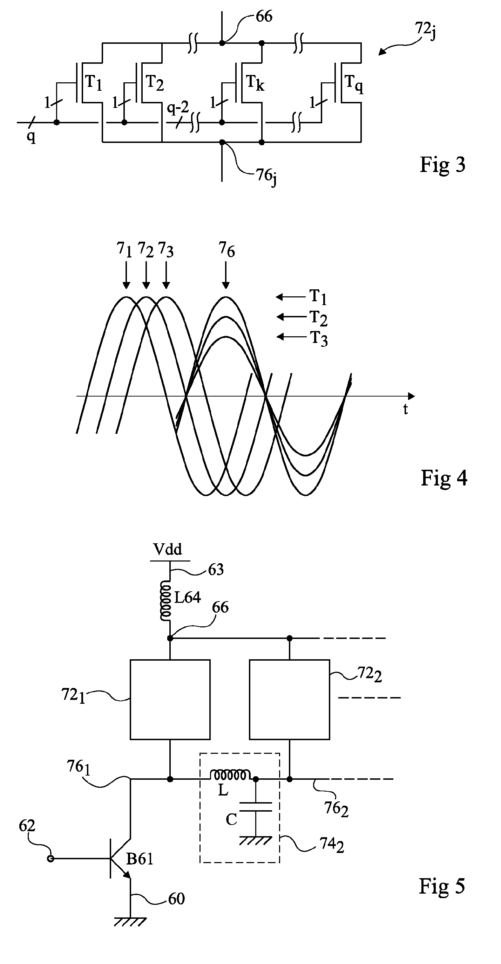

La figure 3 représente un exemple de schéma électrique d'un élément de gain 72ⱼ.

Chaque élément de gain 72ⱼ comporte q transistors T₁, T₂, ..., Tₖ., ..., T_{q} connectés en parallèle entre la borne 66 et le noeud 76ⱼ de l'étage déphaseur concerné. Les transistors Tₖ (k étant compris entre 1 et q) des éléments de gain 72ⱼ sont commandables individuellement depuis le microcontrôleur 1 pour sélectionner le gain. Par exemple, les tailles des transistors T₁ à T_{q} sont différentes et un seul transistor Tₖ est rendu passant entre la borne 66 et le drain du transistor M61. Dans ce cas, chaque élément 72ⱼ comporte autant que transistors en parallèle qu'il y a de niveaux de gain possibles. Selon un autre exemple, plusieurs transistors de l'élément 72ⱼ sont rendus passants pour être en parallèle entre la borne 66 et l'élément retardateur 74ⱼ concerné. Dans ce cas, les tailles respectives des transistors Tₖ peuvent être identiques. Ces deux exemples sont bien entendu combinables.

Dans un mode de réalisation simplifié où le circuit de la figure 2 n'est réglable qu'en phase, chaque élément de gain 72ⱼ comporte un transistor MOS (ou plusieurs transistors en parallèle mais commandés simultanément).

De préférence, le nombre d'étages déphaseurs 7ⱼ dans le circuit PSᵢ est compris entre 2 et 64, et le nombre q de transistors de chaque élément 72ⱼ est compris entre 2 et 8.

On aurait pu penser intercaler des éléments retardateurs en partie haute du montage (entre les noeuds de connexion des étages à la borne 66). Toutefois, cela aurait pour conséquence de désadapter l'impédance en sortie de l'amplificateur en fonction du déphasage. La présence des éléments retardateurs 74ⱼ dans la partie basse du montage (reliés au drain du transistor M61) permet de ne pas désadapter l'impédance en sortie de l'amplificateur.

La figure 4 illustre le fonctionnement du circuit de la figure 2 pour un exemple comportant huit étages 7ⱼ (m=8), chaque élément de gain comportant trois transistors Tₖ (q=3).

Sur une échelle temporelle t, un signal non déphasé (identifié par l'étage 7₁) se trouve de plus en plus déphasé au fur et à mesure que le rang de l'étage sélectionné 7ⱼ augmente. On suppose dans cet exemple que les retards apportés par les différents éléments 74ⱼ sont de même durée, ce qui sera la plupart du temps le cas pour avoir une distribution homogène des lobes de l'antenne adaptative.

L'influence de la sélection de l'un des trois transistors Tₖ de l'étage sélectionné se traduit par une variation d'amplitude, illustrée sur le signal 7₆. Dans cet exemple, on suppose qu'un seul transistor Tₖ est sélectionné à la fois et que la taille (rapport W/L) des transistors décroit du transistor T₁ au transistor T₃.

La figure 5 représente, de façon partielle, un autre mode de réalisation d'un amplificateur déphaseur.

Une première différence par rapport au mode de réalisation de la figure 2 est que le transistor M61 à source commune est remplacé par un transistor bipolaire B61 à émetteur commun (émetteur relié à la masse - borne 69) dont la base est reliée à la borne 62 et dont le collecteur est relié au noeud 76₁.

Une autre différence est que les éléments retardateurs 74ⱼ (seul l'élément 74₂ est représenté en figure 5) sont constitués de circuits discrets comportant une inductance L entre les noeuds 76ⱼ₋₁ et 76ⱼ et un condensateur C entre le noeud 76ⱼ et la masse. Les inductances et condensateurs sont préférentiellement identiques dans les différents étages pour que les lobes soient correctement distribués.

Encore une autre différence, est que la charge 64 est formée par une inductance L64.

Les différences exposées dans le mode de réalisation de la figure 5 par rapport à celui de la figure 2 sont bien entendues combinables.

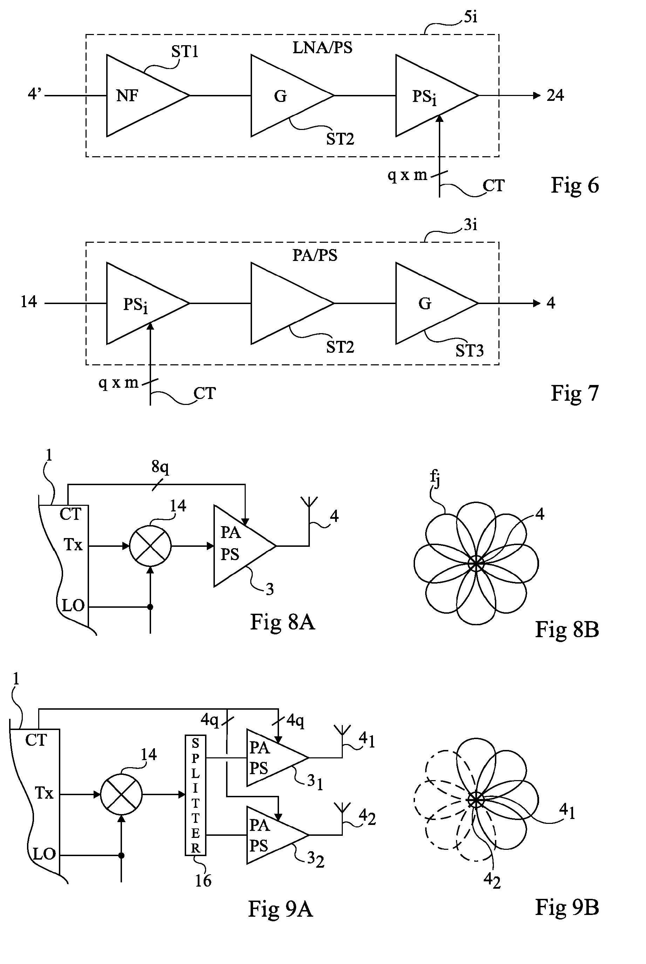

La figure 6 représente, de façon schématique, un mode de réalisation préféré d'un amplificateur de réception 5ᵢ associant l'amplificateur à faible bruit LNA et un déphaseur PS à gain variable. Généralement, un amplificateur à faible bruit comporte plusieurs étages successifs. Dans ce cas, le dernier étage est de préférence constitué du circuit PSᵢ décrit en relation avec la figure 2. Par exemple, un premier étage ST1 (NF - Noise Figure) à faible figure de bruit pour optimiser le rapport signal/bruit. Un deuxième étage ST2 apporte un gain fixe (G) à l'amplificateur. Le troisième étage est constitué de l'amplificateur déphaseur PSᵢ.

Un avantage de placer l'amplificateur déphaseur en dernier étage de l'amplificateur à faible bruit est que cela ne perturbe pas les étages précédents, notamment l'étage de mesure du bruit.

La figure 7 représente, de façon schématique, un amplificateur d'émission 3ᵢ selon un mode de réalisation préféré dans lequel l'amplificateur déphaseur de la figure 2 constitue un premier étage de l'amplificateur d'émission. Ce premier étage est généralement suivi d'un étage intermédiaire ST2 et d'un troisième étage ST3 apportant un gain fixe. Le fait d'introduire le déphasage en entrée de l'amplificateur d'émission permet de préserver la linéarité du signal.

Dans les figures 6 et 7, on a illustré un signal de commande CT sur q*m bits. Toutefois, le signal de commande pourra également être dissocié en un signal sur m bits de sélection d'un seul élément 7ⱼ et un signal sur q bits de sélection d'un ou plusieurs transistors Tₖ.

Les figures 8A et 8B illustrent, de façon schématique un exemple d'application de l'amplificateur déphaseur à une antenne 4 adaptative omnidirectionnelle. La figure 8A représente partiellement la partie émission. La figure 8B illustre les lobes ou faisceaux fⱼ obtenus. Le signal Tx à transmettre, après avoir été converti en analogique (convertisseur non représenté), est modulé (modulateur 14) et attaque un unique amplificateur d'émission 3 comportant autant d'éléments déphaseurs 7ⱼ que de lobes souhaités pour l'antenne. Dans cet exemple, on suppose que l'amplificateur 3 définit huit lobes d'émission pour l'antenne 4. Le microcontrôleur 1 fournit par conséquent 8q signaux de commande CT pour sélectionner à la fois le déphasage et le gain.

Les figures 9A et 9B illustrent de façon schématique un autre exemple d'application à une chaîne d'émission destinée à alimenter deux antennes adaptatives 4₁ et 4₂ rayonnant sur 180° et disposées tête-bêche. La figure 9A représente partiellement la partie émission. La figure 9B illustre les lobes ou faisceaux fⱼ obtenus. Chaque antenne 4ᵢ (n=2) est alimentée par une voie 3₁ ou 3₂ provenant du séparateur 16. Le microcontrôleur 1 fournit 4q signaux de commande à chacun des amplificateurs déphaseurs 3₁ et 3₂. On pourrait également prévoir deux antennes omnidirectionnelles avec des faisceaux intercalés deux à deux.

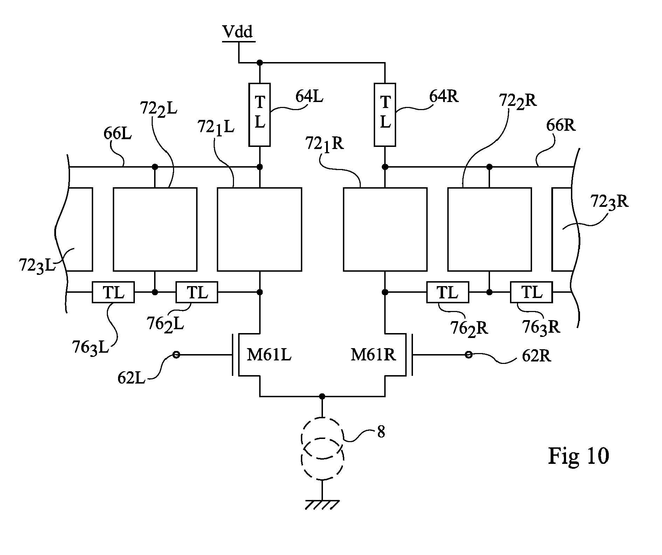

La figure 10 représente un autre mode de réalisation destiné à une architecture différentielle. La structure décrite en relation avec la figure 2 ou la figure 5 est reproduite pour chaque branche différentielle. Les différents éléments ont été référencés avec la lettre L ou R selon la partie gauche ou droite de la structure différentielle de façon arbitraire. Les transistors des circuits 72ⱼL et 72ⱼR de même rang j sont commandés par les mêmes signaux de façon à apporter le même déphasage et le même gain sur les deux voies différentielles.

Comme l'illustre la figure 10, la structure s'adapte à la fois à une architecture différentielle ou pseudodifférentielle si une source de courant 8 (représentée en pointillés en figure 10) est intercalée entre les sources communes des transistors M61L et M61R et la masse.

Un avantage des modes de réalisation décrits est qu'ils permettent de contrôler la phase au niveau des amplificateurs d'émission ou des amplificateurs de réception pour des architectures à antennes adaptatives.

Un autre avantage est que l'amplificateur à réglage de gain et de phase décrit est commandable directement par des signaux numériques.

Un autre avantage est que l'on aboutit à des chaînes de transmission moins encombrantes.

Divers modes de réalisation ont été décrits, diverses variantes et modifications apparaîtront à l'homme de l'art. En particulier, le choix du nombre de phases et du nombre de gains de l'amplificateur dépend du système de transmission et des antennes adaptatives. Ce choix ainsi que l'écart angulaire entre les différents lobes est à la portée de l'homme du métier en fonction de l'application.

De plus, la mise en oeuvre pratique des modes de réalisation décrits est à la portée de l'homme du métier à partir des indications fonctionnelles données ci-dessus.

En outre, bien que l'invention ait été décrite en relation avec un exemple appliqué à une chaîne de transmission RF, l'amplificateur cascode déphaseur décrit peut trouver d'autres applications en électronique, par exemple, dans un récepteur de type superhétérodyne.

## Revendications

1. Amplificateur cascode comportant au moins deux étages déphaseurs commandables (7ⱼ) entre un transistor d'entrée (M61, B61) dont une borne de commande est connectée à une borne d'entrée (62) de l'amplificateur, et une borne de sortie (66) de l'amplificateur, chaque étage déphaseur (7ⱼ) comporte un élément de gain (72ⱼ) en série avec un élément retardateur (74i) entre ladite borne de sortie (66) et ledit transistor d'entrée (M61, B61), chaque élément retardateur reliant le point milieu (76ⱼ) de ladite connexion en série à l'élément retardateur de l'étage de rang (j) précédent.

2. Amplificateur selon la revendication 1, dans lequel chaque élément de gain (72ⱼ) comporte au moins un transistor (Tₖ) reliant ladite borne de sortie (66) à l'élément retardateur (74ᵢ) de l'étage correspondant.

3. Amplificateur selon la revendication 1 ou 2, dans lequel chaque élément de gain (72ⱼ) comporte plusieurs transistors (Tₖ) en parallèle pour rendre le gain de l'amplificateur réglable.

4. Amplificateur selon l'une quelconque des revendications 1 à 3, dans lequel les transistors des éléments de gain (72ⱼ) sont des transistors MOS (Tₖ).

5. Amplificateur selon l'une quelconque des revendications 1 à 4, dans lequel le transistor d'entrée est un transistor MOS (M61) monté en source commune.

6. Amplificateur selon l'une quelconque des revendications 1 à 4, dans lequel le transistor d'entrée est un transistor bipolaire (B61) monté en émetteur commun.

7. Chaîne de transmission radiofréquence à antenne adaptative (4), comportant au moins un amplificateur (PSᵢ) conforme à l'une quelconque des revendications 1 à 6.

8. Chaîne de transmission radiofréquence selon la revendication 7, comportant :
côté émission, un premier amplificateur conforme à l'une quelconque des revendications 1 à 6 (PSᵢ) forme un premier étage d'un amplificateur d'émission (3) ; et
côté réception, un deuxième amplificateur conforme à l'une quelconque des revendications 1 à 6 (PSᵢ) forme un dernier étage d'un amplificateur à faible bruit (5).
